# EUROPEAN PATENT APPLICATION

(11) **EP 0 812 015 A1**
(43) Date of publication of application: **10.12.1997**
(21) Application number: 97108845.5
(22) Date of filing: 03.06.1997
(51) Int. Cl.: H01L 23/367

(54) **A heat dissipator for integrated circuits**

(30) Priority: 04.06.1996 IT TO960486
(71) Applicant: MAGNETI MARELLI S.p.A., 20145 Milano (IT)
(72) Inventor: Nardoni, Marco, 27100 Pavia (IT); Nitopi, Luca, 16157 Genova (IT)
(74) Representative: Quinterno, Giuseppe

(57) **Abstract**

A heat dissipator (D) for an integrated circuit (IC) of the Flip Chip type, made of copper sheet, intended to be soldered to the metallised Back Side of the integrated circuit (IC) and to two metallised areas (PS) of the interconnection substrate (P), after the soldering phase between the integrated circuit (IC) and the interconnection substrate (P), by means of a low-fusion soldering alloy (SBT) so as not to impair the soldering, and thus the alignment, between the integrated circuit (IC) and the interconnection substrate (P), carried out using a high-fusion soldering paste (SAT).

## Description

The present invention relates in general to heat dissipators for electronic components, in particular to semiconductor heat dissipators, assembled using so-called Flip Chip technology. More specifically, the present invention relates to a heat dissipator for such components which is also able to form a connection between the components and the rest of the system in which they are used.

A semiconductor device is known to consist of a very small and very thin wafer, typically made of silicon and known as a chip, on which the various components and their interconnections are formed. Such a semiconductor device, or chip, is generally an integrated circuit and will also be referred to by this term in the following description.

One face of the chip, commonly known as the upper face, has metallised pads operable to electrically connect the chip to an interconnection substrate by means of conductive wires. The lower face of the chip, opposite the upper face, is sometimes used as a further electrical connection to the rest of the system.

Flip Chip technology consists essentially in mounting the chip upside-down, that is with its upper face facing the interconnection substrate, so as to make the pads correspond geometrically with the terminals of conductive tracks formed on the substrate. Mechanical and electrical connection may be carried out by various methods: by soldering or by using conductive adhesives. Any interconnection substrate used in the normal assembly of electronic components can also be used in Flip Chip technology.

Typically, before a Flip Chip circuit is assembled, substances are deposited on the pads, either by a chemical process or by screen printing, to facilitate this assembly; for example, the pads are made wettable by the usual soldering agents used in soldering components with a container, or small quantities of these soldering agents are deposited directly onto the pads. Sometimes the same substances are also deposited on the conductive tracks of the substrate.

The next assembly phase consists in aligning the chip in its correct position, after which the substrate is usually put through a remelting oven at a temperature selected for the soldering agents or adhesives used.

The dimensions of the pads, and thus of the connector tracks on the substrate are typically of the order of tenths of a millimetre, so the highest possible degree of accuracy is required during the alignment step.

Once soldering has been carried out, the hollow space between the chip and the substrate is filled with plastics resin to protect the assembly from environmental contamination.

The structure obtained with this assembly is thus constituted by a silicon wafer, the chip, containing the electronic components, the substrate to which the chip is soldered and a layer of plastics resin between the two.

In this configuration, the chip can dissipate heat generated inside it only towards the substrate, through the filler resin between the chip and the substrate. Owing to the low thermal conductivity of the plastics resins which can be used, heat dissipation takes place only with some difficulty. With this type of assembly any dissipation through the lower face of the chip, opposite that carrying the pads and commonly known as the Back Side, can be disregarded (as will be explained later). This Back Side is generally metallised.

The prior art provides several arrangements for increasing heat dissipation from the chip by using a heat conductive element to connect the Back Side of the chip to conventional heat dissipating fins or to metal structures operable to dissipate heat.

Such arrangements do dissipate heat from the chip, or integrated circuit, but have other technical disadvantages. A first disadvantage involves the dimensions and the cost of the dissipating fin itself. A second disadvantage is due to the fact that it is often necessary to make an electrical connection between the metallised lower face of the integrated circuit and the interconnection substrate. If a dissipating fin is applied to the metallised lower face of the integrated circuit, it is very difficult to set up such an electrical connection. This is because a heat-conductive paste, typically silicon grease, is used to ensure good thermal contact between the dissipating fin and the lower face of the integrated circuit. This heat-conductive paste makes it difficult to achieve a good electrical contact between the dissipating fin and the metallised lower face of the integrated circuit. In addition, it is difficult to solder an electrical conductor directly to the metallised lower face of the integrated circuit owing to the presence of the heat dissipating fin.

The object of the present invention is to provide a heat dissipator for integrated circuits or semiconductor devices such as Flip Chips which satisfactorily solves all the above problems.

This object is achieved according to the present invention by providing a heat dissipator for integrated circuits or semiconductor devices of the Flip Chip type having the characteristics claimed in the Claims which follow this description.

Further advantages and characteristics of the present invention will become clear from the following detailed description with the aid of the appended drawings, provided purely by way of non-limitative example, in which:
Figure 1 is a partial schematic perspective view of a prior art connection between a semiconductor and an interconnection substrate,
Figure 2 is a partial schematic perspective view of a semiconductor device and an interconnection substrate according to the present invention, and
Figure 3 is a partial schematic perspective view, in cross section, of an interconnection substrate carrying a semiconductor device and a heat dissipator, according to the present invention.
The present invention essentially comprises a heat dissipator, and the assembly thereof, operable to ensure optimum heat and electrical conduction between the metallised lower face or Back Side of the semiconductor device or integrated circuit and the interconnection substrate.

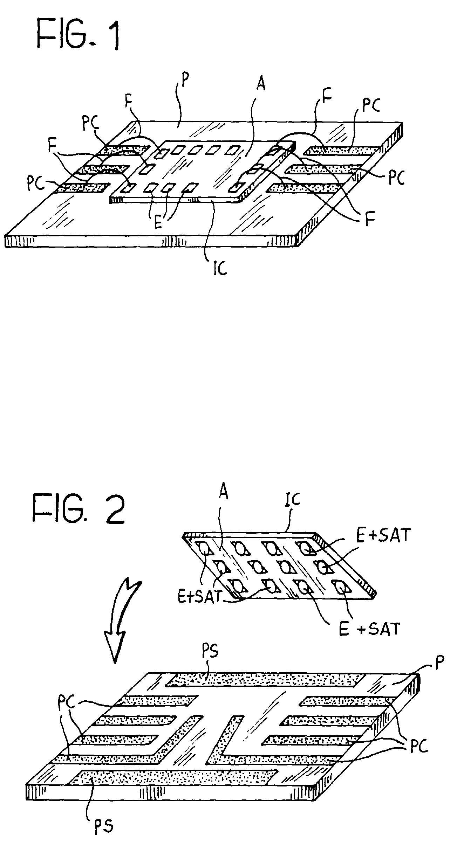

Figure 1 shows the "conventional" method of electrically connecting a semiconductor device, chip or integrated circuit, IC and an electrical interconnection substrate P; note the conductive wires F which electrically connect the connective patches, or pads E on an upper face A of the semiconductor device IC to conductive tracks PC in the interconnection substrate P.

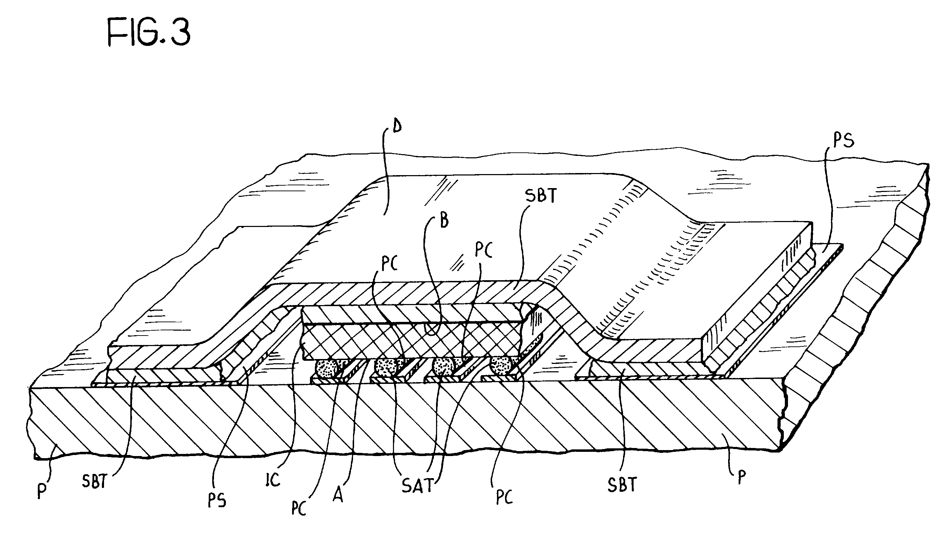

In order better to understand the heat dissipator of the invention, it will now be described in detail with reference to Figures 2 and 3.

It can be seen that Figures 2 and 3 also show an interconnection substrate P made from a plate, for example of ceramic material, on which have been formed conductive tracks PC according to techniques widely known in the art. The integrated circuit IC is placed on the interconnection substrate P. As explained above, the upper face A of the integrated circuit IC, that is the face on which the connecting pads E are formed, faces the interconnection substrate P. In practice, the integrated circuit IC is arranged "upside-down" on the printed circuit P, that is with the upper face A facing (in the case of Figures 2 and 3) downwards, that is towards the substrate P, and the lower face B, or Back Side, facing upwards.

As stated above, the pads E of the integrated circuit IC are soldered to corresponding conductive tracks PC of the substrate P by means of deposits of soldering paste SAT.

In the case of the present invention, the deposits SAT must be made using a soldering paste which melts at a relatively high temperature, that is a so-called high-fusion paste. It may be advantageous, for example, to use a soldering paste SAT with a fusion temperature of 220°C. The integrated circuit IC and the interconnection substrate P are soldered, for example, in a soldering oven, naturally at a temperature higher than the fusion temperature of the soldering paste used for the deposits SAT.

Once the integrated circuit IC and the substrate P have been soldered, a heat sink or dissipator D is fitted to the integrated circuit. This dissipator D is made of sheet metal and is shaped so as to have a first flat surface for locating on the metallised lower face B of the integrated circuit IC and at least a second flat surface intended to be positioned on an area PS of the substrate P close to the integrated circuit IC.

The dissipator D can, for example, be made of a substantially rectangular sheet of metal bent into the shape of a broad-based "U" as shown in Figure 3. As can be seen from Figure 3, the dissipator D has a central portion resting on the metallised lower face B of the integrated circuit IC and two flat side portions which are bent twice so they are lower than the central portion and resting on two areas PS of the substrate P adjacent the integrated circuit IC. It is possible, however, for the dissipator D to be shaped differently. The dissipator D can advantageously be made in copper or an alloy thereof although it is possible to use other metals, provided they are good conductors of both electricity and heat.

The surface of the sheet used to form the dissipator D intended to face the interconnection substrate P may be pre-tinned, at least in the areas which will come into contact with the metallised lower face B of the integrated circuit IC and with the areas PS of the substrate P. In addition, these areas PS of the substrate P intended to come into contact with portions of the dissipator D are metallised, at least partially, and may carry conductive tracks.

The soldering paste SBT used to solder the dissipator D must be a paste with a significantly lower fusion temperature than the fusion temperature of the soldering paste used for the deposits SAT. It would be advantageous to use, for example, an eutectic tin-lead soldering paste with a fusion temperature of 183°C.

Alternatively, a low fusion temperature paste SBT can be applied to one surface of the dissipator D or on the Back Side B of the integrated circuit IC and on the metallised areas PS of the substrate P intended to come into contact with the dissipator D.

The substrate P on which the dissipator D rests can then be returned to a soldering oven so as to solder the dissipator D to the integrated circuit IC and to the areas PS of the substrate P. This soldering process must of course be carried out at a temperature higher than the fusion temperature of the low-temperature soldering alloy or paste SBT but lower than the fusion temperature of the paste used for the deposits SAT. In the example described above, in which the soldering paste used for the deposits SAT has a fusion temperature of 220°C, and the soldering alloy SBT has a fusion temperature of 183°C, this second soldering operation may be carried out, for example, at a temperature of between 200 and 210°C.

In this way, the paste deposits SAT which solder the integrated circuit IC to the printed circuit P do not melt but remain intact during the soldering of the heat dissipator D. If this were not the case, that is if during the soldering of the heat dissipator D the paste applications SAT soldering the integrated circuit IC to the substrate P became molten, the alignment of the integrated circuit IC and the tracks PC of the substrate P, which must be extremely accurate as stated above, would be impaired, along with the connections between the pads E of the integrated circuit IC and the conductive tracks PC of the substrate P, thereby rendering the circuit unusable. Working as described above poses no risk of this happening.

Furthermore, should it be necessary to make an electrical connection with the metallised lower face B of the integrated circuit IC, it would be possible to use one of the conductive tracks PS intended to enable the heat dissipator D to be soldered to the substrate P.

By using the heat dissipator D, the invention thus makes it possible to set up an optimum thermal and electrical connection between the metallised lower face B of the integrated circuit IC and the substrate P.

The invention thus has the advantage of making it possible to use Flip Chip technology for power components. The invention also makes it possible to manufacture circuits which include components using both Flip Chip technology and SMD technology, that is surface mounted components, which can be soldered to the interconnection substrate P during the second soldering operation, for example.

Naturally, the principle of the invention remaining unchanged, manufacturing details and embodiments may be varied widely from those described and illustrated here, without thereby departing from the protective scope of the present invention as defined in the appended Claims.

## Claims

1. A heat dissipator for an integrated circuit or semiconductor device (IC), of the Flip Chip type, intended to be soldered directly to an interconnection substrate (P), with an upper face (A) of the said integrated circuit (IC) having several metallised connection pads (E) and facing the said interconnection substrate (P), the said metallised connection pads (E) being soldered directly to connective tracks (PC) of the interconnection substrate (P) by means of applications (SAT) of soldering paste having a first fusion temperature,
characterised in that it is constituted by a metal element (D), being both electrically and thermally conductive, made so as to have a first, substantially flat surface, intended to be soldered to a metallised lower face (B) of the said integrated circuit (IC), and at least one second substantially flat surface intended to be soldered to a metallised area (PS) of the said interconnection substrate (P), adjacent the said integrated circuit (IC), by means of a soldering alloy (SBT) having a second fusion temperature.

2. A dissipator according to Claim 1, characterised in that it is constituted by an element (D) of bent sheet metal.

3. A dissipator according to Claim 1 or Claim 2, characterised in that the said metal element (D) has two second substantially flat surfaces intended to be soldered to two metallised areas (PS) of the said interconnection substrate (P) adjacent two opposite edges of the said integrated circuit (IC).

4. A dissipator according to any Claim from 1 to 3, characterised in that the said metal element (D) is made of copper or a copper alloy.

5. A dissipator according to any Claim from 1 to 4, characterised in that the said metal element (D) is soldered to the said integrated circuit (IC) and to the said interconnection substrate (P) by means of the said soldering alloy or paste (SBT) having a second fusion temperature lower than the first fusion temperature whereby the said metal element (D) can be soldered to the said integrated circuit (IC) and the said substrate (P), already soldered to each other, without causing fusion of the soldering already carried out with the applications of soldering paste (SAT).

6. A dissipator according to Claim 5, characterised in that the said soldering alloy (SBT) is applied to one face of the said metal element (D), at least on the said first and second surfaces, before it is soldered.

7. A dissipator according to Claim 5, characterised in that the said soldering paste (SBT) is applied to the said lower face (B) of the said integrated circuit (IC) and to the said metallised area (PS) of the said interconnection substrate (P) adjacent the said integrated circuit (IC).

8. A manufacturing process for an interconnection substrate (P) which includes at least one integrated circuit (IC) of the Flip Chip type and a heat dissipator (D) according to any one of Claims 1 to 7, characterised in that it includes, in order, at least the following steps:
- soldering the said integrated circuit (IC) to the said interconnection substrate (P) at a temperature higher than the said first fusion temperature, and
- soldering the said dissipator (D) to the said integrated circuit (IC) and the said interconnection substrate (P) at a temperature lower than the said first fusion temperature but higher than the said second fusion temperature.
